# EUROPÄISCHE PATENTSCHRIFT

(11) **EP 3 314 275 B1**
(45) Veröffentlichungstag und Bekanntmachung des Hinweises auf die Patenterteilung: **04.08.2021**
(21) Anmeldenummer: 16731055.6
(22) Anmeldetag: 09.06.2016
(51) Int. Cl.: G01R 19/14, G01R 31/36, G01R 31/392, G01R 31/396

(54) **MESSANORDNUNG ZUM ERKENNEN EINER FEHLFUNKTION IN EINER ENERGIESPEICHERANORDNUNG**
MEASURING ARRANGEMENT FOR IDENTIFYING A MALFUNCTION IN AN ENERGY ACCUMULATOR ARRANGEMENT
DISPOSITIF DE MESURE POUR L'IDENTIFICATION D'UNE FONCTION DÉFICIENTE DANS UN DISPOSITIF ACCUMULATEUR D'ÉNERGIE

(30) Priorität: 24.06.2015 DE 102015110183
(43) Veröffentlichungstag der Anmeldung: 02.05.2018
(73) Patentinhaber: Phoenix Contact GmbH & Co. KG, 32825 Blomberg (DE)
(72) Erfinder: NEUMANN, Daniel, 33039 Nieheim (DE); MANTLER, Eugen, 32839 Steinheim (DE)
(74) Vertreter: Patentship Patentanwaltsgesellschaft mbH
(86) Internationale Anmeldenummer: PCT/EP2016/063203
(87) Internationale Veröffentlichungsnummer: WO 2016/206987

(56) Entgegenhaltungen:
- EP-A1- 2 669 988
- EP-A2- 0 982 830
- EP-A2- 1 203 964
- WO-A2-2013/182440
- US-A1- 2012 182 021

## Beschreibung

Die vorliegende Erfindung betrifft eine Messanordnung zur Überwachung von Energiespeichern einer Energiespeicheranordnung und zur Identifizierung von fehlerhaften Energiespeichern der Energiespeicheranordnung.

Energiespeicheranordnungen, welche aus mehreren elektrisch verbundenen Energiespeichern bestehen, werden beispielsweise in unterbrechungsfreien Stromversorgungen (USV) eingesetzt. Die Aufgabe einer USV ist es, elektrische Anlagen, welche an ein Stromnetz angeschlossen sind, vor Störungen in dem Stromnetz zu schützen. Im Falle eines Ausfalls oder einer Schwankung des Netzstroms können die Energiespeicher der USV innerhalb weniger Millisekunden die Stromversorgung der elektrischen Anlage übernehmen. Bei den Energiespeichern der USV handelt es sich häufig um Akkumulatoren, beispielsweise um Lithium-Polymer-Akkumulatoren. Diese Energiespeicher sind meist parallel verschaltet um einen gemeinsamen Energiespeicher mit hoher Ladekapazität zu bilden.

Während der Lebenszeit einer USV sind die Energiespeicher einem Alterungsprozess ausgesetzt, beispielsweise aufgrund der Belastung durch regelmäßige Auf- und Entladevorgänge, oder aufgrund von Temperaturschwankungen. Dies kann zu frühzeitigen Defekten einzelner Energiespeicher der Energiespeicheranordnung führen. Defekte in einzelnen Energiespeichern können die Sicherheit des USV-Systems verringern und im Extremfall zu einem kompletten Ausfall des USV-Systems führen. Die meist parallele Verschaltung erschwert die Auswertung der einzelnen Energiespeicher, so dass ein einzelner fehlerhafter Energiespeicher in der Energiespeicheranordnung schwer zu identifizieren ist.

Aus den Druckschriften WO 2013 / 182440 A2, US 2012 / 182021 A1 und EP 0 982 830 A2 sind weitere Energiespeicheranordnungen bekannt.

Die Druckschrift EP 2 669 988 A1 betrifft eine Batteriepackung und einen Leistungsverbraucher. In Figur 2 ist eine solche Batteriepackung 10 mit sechs sekundären Batteriezellen 21 und einer Steuerschaltung 11 dargestellt.

Es ist die der Erfindung zugrundeliegende Aufgabe, eine Messanordnung zur Überwachung von Energiespeichern einer Energiespeicheranordnung und zur Identifizierung von fehlerhaften Energiespeichern der Energiespeicheranordnung zu schaffen.

Diese Aufgabe wird durch Gegenstände mit den Merkmalen nach den unabhängigen Ansprüchen gelöst. Vorteilhafte Ausführungsformen der Erfindung sind Gegenstand der Figuren, der Beschreibung und der abhängigen Ansprüche.

Gemäß einem ersten Aspekt der Erfindung wird die Aufgabe durch eine Messanordnung zum Erkennen einer Fehlfunktion in einer Energiespeicheranordnung mit einem ersten Energiespeicher und mit zumindest einem weiteren Energiespeicher gelöst, mit: einer Messeinrichtung, welche ausgebildet ist, eine elektrische Messgröße des ersten Energiespeichers und eine elektrische Messgröße des weiteren Energiespeichers der Mehrzahl der Energiespeicher zu messen; einer Schaltungsanordnung mit einem ersten steuerbaren Schalter zum elektrischen Verbinden des ersten Energiespeichers mit der Messeinrichtung, und mit einem weiteren steuerbaren Schalter zum elektrischen Verbinden des weiteren Energiespeichers mit der Messeinrichtung; einer Prozessoreinrichtung zur Steuerung der steuerbaren Schalter der Schaltungsanordnung, wobei die Prozessoreinrichtung ausgebildet ist, zur Erfassung der elektrischen Messgröße des ersten Energiespeichers den ersten Schalter geschlossen zu halten und den weiteren Schalter zu öffnen, um den weiteren Energiespeicher von der Messeinrichtung abzutrennen, und zur Erfassung der elektrischen Messgröße des weiteren Energiespeichers den weiteren Schalter geschlossen zu halten und den ersten Schalter zu öffnen, um den ersten Energiespeicher von der Messeinrichtung abzutrennen. Dadurch wird der Vorteil erreicht, dass mit der Messanordnung die elektrische Messgröße eines jeden Energiespeichers der Energiespeicheranordnung effizient und unbeeinflusst von den anderen Energiespeichern der Energiespeicheranordnung erfasst werden kann.

Die Messanordnung kann als abgeschlossenes Modul vorliegen, welches beispielsweise ein Gehäuse umfasst, in dem alle Komponenten der Messanordnung angeordnet sind. Dieses Modul kann elektrische Anschlüsse für eine externe Energiespeicheranordnung vorsehen. Ferner kann die Messanordnung zusammen mit der Energiespeicheranordnung ein abgeschlossenes Bauteil bilden, in welchem beispielsweise die Komponenten der Messanordnung und die Energiespeicher in einem gemeinsamen Gehäuse angeordnet sind.

Bei den Energiespeichern kann es sich um Akkumulatoren, beispielsweise Lithium-Ionen-Akkumulatoren, Lithium-Polymer-Akkumulatoren oder Bleiakkumulatoren, handeln, welche eine Akkumulator-Spannung von beispielsweise 12 oder 24 Volt aufweisen können. Dabei können die Energiespeicher, die in der Energiespeicheranordnung miteinander elektrisch verbunden sind, gleichen Typs sein und eine gleiche Spannung und eine gleiche Säuredichte aufweisen.

Die steuerbaren Schalter der Schaltungsanordnung können Transistorschalter, insbesondere MOSFET-Schalter, sein. Insbesondere kann jeder steuerbare Schalter aus einer elektrischen Schaltung bestehen, welche zwei in Reihe geschaltete MOSFET-Schalter umfasst, deren Source-Anschlüsse elektrisch verbunden sind. Zusätzlich kann zur Spannungsbegrenzung eine Zener-Diode zwischen die Source- und die Gate-Anschlüsse der MOSFET-Schalter geschalten werden.

Die Prozessoreinrichtung kann ein Mikrocontroller sein, wobei der Mikrocontroller einen Prozessor und/oder einen Speicher umfassen kann. Die Prozessoreinrichtung kann mit der Messeinrichtung zum Empfang der gemessenen elektrischen Messgrößen elektrisch verbunden sein. Ferner kann die Prozessoreinrichtung derart konfiguriert sein, dass sie Parameterwerte aus den empfangenen elektrischen Messgrößen berechnet. Handelt es sich bei den steuerbaren Schaltern um Transistorschalter, so kann die Prozessoreinrichtung zur Steuerung der steuerbaren Schalter mit den Gate-Elektroden der Transistorschalter elektrisch verbunden sein und diese durch das Anlegen einer Gate-Spannung elektrisch steuern. Um bei der Ansteuerung der Gate-Elektroden der Transistorschalter eine ausreichend hohen Gate-Spannung bereitzustellen können Gleichspannungswandler, beispielsweise Hochsetzsteller oder Ladungspumpen, zwischen die Prozessoreinrichtung und die Gate-Elektroden der Transistorschalter geschaltet sein.

In einer vorteilhaften Ausführungsform der Messanordnung weist die Schaltungsanordnung eine Mehrzahl von steuerbaren Schaltern auf, wobei jeder steuerbare Schalter ausgebildet ist, einen Energiespeicher der Mehrzahl von Energiespeichern mit der Messeinrichtung elektrisch zu verbinden, und wobei die Prozessoreinrichtung ausgebildet ist, zur Erfassung der elektrische Messgröße des ersten Energiespeichers nur den ersten steuerbaren Schalter zu schließen oder geschlossen zu halten und alle anderen steuerbaren Schalter zu öffnen oder geöffnet zu lassen. Dadurch wird der Vorteil erreicht, dass die elektrische Messgröße des ersten Energiespeichers während ihrer Erfassung nicht durch die elektrischen Eigenschaften eines weiteren Energiespeichers der Energiespeicheranordnung beeinflusst werden kann.

In einer weiteren vorteilhaften Ausführungsform der Messanordnung ist die Schaltungsanordnung ausgebildet, den ersten Energiespeicher und den weiteren Energiespeicher im Betrieb der Energiespeicher parallelzuschalten. Dadurch wird der Vorteil erreicht, dass auf effiziente Weise ein gemeinsamer Energiespeicher mit erhöhter Ladekapazität und erhöhter Lebensdauer geschaffen werden kann.

In einer weiteren vorteilhaften Ausführungsform ist die Messanordnung in einem Testmodus und in einem Betriebsmodus betreibbar, wobei die elektrische Messgröße des ersten Energiespeichers und die elektrische Messgröße des weiteren Energiespeichers in dem Testmodus erfasst werden, und wobei die Schaltungsanordnung in dem Betriebsmodus ausgebildet ist, den ersten Energiespeicher und den weiteren Energiespeicher parallelzuschalten. Dadurch wird der Vorteil erreicht, dass die Energiespeicher in einem zeitlich beschränkten Testmodus effizient auf ihre Funktionstüchtigkeit getestet werden können, während die Messanordnung im Betriebsmodus einen optimalen Betriebszustand der Energiespeicheranordnung gewährleisten kann.

In einer weiteren vorteilhaften Ausführungsform der Messanordnung ist die Messeinrichtung ausgebildet, die elektrischen Messgröße des ersten Energiespeichers und die elektrische Messgröße des weiteren Energiespeichers in zeitlich aufeinanderfolgenden Messintervallen zu erfassen, wobei innerhalb eines Messintervalls genau nur ein Schalter der Schaltungsanordnung geschlossen ist und alle anderen Schalter der Schaltungsanordnung geöffnet sind. Dadurch wird der Vorteil erreicht, dass die Messung einer elektrischen Messgröße eines Energiespeichers effizient und unbeeinflusst von den anderen Energiespeichern der Energiespeicheranordnung erfolgen kann.

In einer weiteren vorteilhaften Ausführungsform der Messanordnung ist die Prozessoreinrichtung ausgebildet, innerhalb eines ersten Messintervalls nur den ersten Schalter geschlossen zu halten und den weiteren Schalter zu öffnen, und innerhalb eines weiteren Messintervalls nur den weiteren Schalter geschlossen zu halten und den ersten Schalter zu öffnen. Dadurch wird der Vorteil erreicht, dass die Erfassung der elektrischen Messgröße eines jeden Energiespeichers der Energiespeicheranordnung unbeeinflusst von den anderen Energiespeichern der Energiespeicheranordnung erfolgen kann.

In einer weiteren vorteilhaften Ausführungsform der Messanordnung weist die Messeinrichtung eine mit dem ersten steuerbaren Schalter verbundene erste Messeinheit zur Messung der elektrischen Messgröße des ersten Energiespeichers, insbesondere eines Innenwiderstandes, einer Spannung, oder eines Stroms, auf, und weist die Messeinrichtung eine mit dem weiteren steuerbaren Schalter verbundene weitere Messeinheit zur Messung der elektrischen Messgröße des weiteren Energiespeichers, insbesondere eines Innenwiderstandes, einer Spannung, oder eines Stroms, auf, und/oder weist die Messeinrichtung eine mit dem ersten steuerbaren Schalter und weiteren steuerbaren Schalter verbundene gemeinsame Messeinheit zur Messung einer gemeinsamen elektrischen Messgröße, insbesondere eines Innenwiderstandes, einer Spannung, oder eines Stroms, des ersten Energiespeichers und des weiteren Energiespeichers auf. Dadurch wird der Vorteil erreicht, dass die elektrischen Messgrößen eines jeden einzelnen Energiespeichers und eine gemeinsame elektrische Messgröße aller Energiespeicher effizient erfasst werden können.

In einer weiteren vorteilhaften Ausführungsform der Messanordnung weist die Messeinrichtung zusätzlich eine Umgebungsmesseinheit zur Messung eines Umgebungsparameters, insbesondere einer Temperatur, auf. Dadurch wird der Vorteil erreicht, dass der Umgebungsparameter von der Messanordnung bei der Überwachung der Energiespeicher und bei der Identifizierung von fehlerhaften Energiespeichern berücksichtigt werden kann. Handelt es sich bei dem Umgebungsparameter um eine Temperatur, so können über Messungen des Temperaturverlaufs beispielsweise Rückschlüsse auf den Alterungsprozess der Energiespeicher gezogen werden.

In einer weiteren vorteilhaften Ausführungsform der Messanordnung ist die Prozessoreinrichtung ausgebildet, die gemessenen elektrischen Messgrößen auszuwerten, insbesondere mit elektrischen Referenzgrößen zu vergleichen, um eine Fehlfunktion des ersten Energiespeichers oder des weiteren Energiespeichers zu erfassen. Dadurch wird der Vorteil erreicht, dass einzelne defekte Energiespeicher in der Energiespeicheranordnung effizient identifiziert werden können.

In einer weiteren vorteilhaften Ausführungsform der Messanordnung ist die Prozessoreinrichtung dazu ausgebildet, aus der elektrischen Messgröße des ersten Energiespeichers, insbesondere aus einem Ladestrom des ersten Energiespeichers, und aus der elektrischen Messgröße des weiteren Energiespeichers, insbesondere aus einem Ladestrom des weiteren Energiespeichers, die aktuelle Ladekapazität des ersten Energiespeichers und die aktuelle Ladekapazität des weiteren Energiespeichers zu ermitteln, wobei eine Fehlfunktion des ersten Energiespeichers festgestellt wird, falls die Ladekapazität des ersten Energiespeichers einen Referenzwert der Nennladung des ersten Energiespeichers entspricht und der Ladestrom des ersten Energiespeichers größer ist als ein Referenzwert des Erhaltungsladestroms des ersten Energiespeichers, und wobei eine Fehlfunktion des weiteren Energiespeichers festgestellt wird, falls die aktuelle Ladekapazität des weiteren Energiespeichers einen Referenzwert der Nennladung des weiteren Energiespeichers entspricht und der Ladestrom des weiteren Energiespeichers größer ist als ein Referenzwert des Erhaltungsladestroms des weiteren Energiespeichers. Dadurch wird der Vorteil erreicht, dass fehlerhafte Energiespeicher der Energiespeicheranordnung im Ladebetrieb der Energiespeicheranordnung effizient identifiziert werden können.

In einer weiteren vorteilhaften Ausführungsform der Messanordnung ist die Prozessoreinrichtung ausgebildet, bei erfasster Fehlfunktion des ersten Energiespeichers den ersten steuerbaren Schalter dauerhaft zu öffnen, um den ersten Energiespeicher abzutrennen, oder bei erfasster Fehlfunktion des weiteren Energiespeichers den weiteren steuerbaren Schalter dauerhaft zu öffnen, um den weiteren Energiespeicher abzutrennen. Dadurch wird der Vorteil erreicht, dass eine negative Beeinflussung der Energiespeicheranordnung durch einen fehlerhaften Energiespeicher verhindert werden kann.

In einer weiteren vorteilhaften Ausführungsform der Messanordnung ist die Schaltungsanordnung ausgebildet, den ersten elektrischen Energiespeicher und den weiteren elektrischen Energiespeicher parallel zu schalten, und ist die Messeinrichtung ausgebildet, eine Polarität der elektrischen Messgröße des ersten Energiespeichers und eine Polarität einer weiteren elektrischen Messgröße in der Energiespeicheranordnung zu erfassen, wobei die Prozessoreinrichtung ausgebildet ist, die Fehlfunktion der Energiespeicheranordnung durch einen Vergleich der Polarität der elektrischen Messgröße des ersten Energiespeichers und der Polarität der weiteren elektrischen Messgröße zu erkennen. Dadurch wird der Vorteil erreicht, dass eine Fehlfunktion eines Energiespeichers der Energiespeicheranordnung im laufenden Betrieb und ohne eine Einschränkung der Nutzung der Energiespeicheranordnung erfasst werden kann.

In einer weiteren vorteilhaften Ausführungsform der Messanordnung ist die Prozessoreinrichtung ausgebildet, die Fehlfunktion eines Energiespeichers der Energiespeicheranordnung zu erkennen, falls die Polarität der elektrischen Messgröße des ersten Energiespeichers und die Polarität der weiteren elektrischen Messgröße unterschiedlich sind. Dadurch wird der Vorteil erreicht, dass eine effiziente Identifizierung eines fehlerhaften Energiespeichers erfolgen kann.

In einer weiteren vorteilhaften Ausführungsform der Messanordnung ist die Messeinrichtung ausgebildet, die Polarität der elektrischen Messgröße des ersten Energiespeichers und die Polarität der weiteren elektrischen Messgröße durch Erfassung einer elektrischen Richtung der elektrischen Messgröße des ersten Energiespeichers und der weiteren elektrischen Messgröße zu erfassen. Dadurch wird der Vorteil erreicht, dass eine effiziente Erfassung der Polaritäten der gemessenen elektrischen Messgrößen erfolgen kann.

In einer weiteren vorteilhaften Ausführungsform der Messanordnung ist die weitere elektrische Messgröße eine elektrische Messgröße des weiteren Energiespeichers, oder ist die weitere elektrische Messgröße eine elektrische Messgröße an einem Verbindungspunkt des ersten Energiespeichers und des weiteren Energiespeichers. Dadurch wird der Vorteil erreicht, dass die Polarität der elektrischen Messgrößen einzelner Energiespeichers der Energiespeicheranordnung und die Polarität gemeinsamer elektrischer Messgrößen mehrerer Energiespeicher der Energiespeicheranordnung zur Identifizierung eines fehlerhaften Energiespeichers genutzt werden können.

In einer weiteren vorteilhaften Ausführungsform der Messanordnung ist die erste Messeinheit zur Erfassung der Polarität der elektrischen Messgröße des ersten Energiespeichers ausgebildet, und ist eine weitere Messeinheit zur Erfassung der Polarität der weiteren elektrischen Messgröße ausgebildet. Dadurch wird der Vorteil erreicht, dass die Polarität der elektrischen Messgröße eines jeden Energiespeichers der Energiespeicheranordnung effizient erfasst werden kann.

In einer weiteren vorteilhaften Ausführungsform der Messanordnung weist die Messeinrichtung eine gemeinsame Messeinheit zur Erfassung der Polarität der elektrischen Messgröße an dem Verbindungspunkt des ersten Energiespeichers und des weiteren Energiespeichers auf, um eine gemeinsame Polarität zu erhalten, und ist die Prozessoreinrichtung ausgebildet, die Fehlfunktion der Energiespeicheranordnung durch einen Vergleich der Polarität der elektrischen Messgröße des ersten Energiespeichers oder der Polarität der weiteren elektrischen Messgröße mit der gemeinsamen Polarität zu erkennen. Dadurch wird der Vorteil erreicht, dass eine effiziente Identifizierung der fehlerhaften Energiespeicher in der Energiespeicheranordnung erfolgen kann.

In einer weiteren vorteilhaften Ausführungsform der Messanordnung gibt die Messanordnung bei Erkennung eines defekten Energiespeichers ein akustisches oder optisches Warnsignal aus. Dadurch wird der Vorteil erreicht, dass ein Benutzter bei Vorliegen eines defekten Energiespeichers der Energiespeicheranordnung gewarnt werden kann. Bei dem akustischen Warnsignal kann es sich um einen durchgehenden oder periodischen Warnton handeln. Bei dem optischen Warnsignal kann es sich um ein durchgehendes oder periodisches Leuchten eines Leuchtelements in einer Signalfarbe handeln.

In einer weiteren vorteilhaften Ausführungsform der Messanordnung umfasst die Messanordnung den ersten Energiespeicher und den weiteren Energiespeicher. Dadurch wird der Vorteil erreicht, dass eine erweiterte Energiespeicheranordnung geschaffen werden kann, welche die in ihr integrierten Energiespeicher überwachen und fehlerhafte Energiespeicher identifizieren kann.

In einer weiteren vorteilhaften Ausführungsform der Messanordnung weist die Messanordnung einen Verbindungsanschluss zum Verbinden der Schaltungsanordnung mit einer Hilfsenergieversorgungsvorrichtung, insbesondere einer unterbrechungsfreien Spannungsversorgung, auf, um die elektrischen Energiespeicher für die Hilfsenergieversorgung bereitzustellen. Dadurch wird der Vorteil erreicht, dass eine Hilfsenergieversorgungsvorrichtung mit hoher Zuverlässigkeit geschaffen werden kann.

In einer weiteren vorteilhaften Ausführungsform der Messanordnung umfasst die Hilfsenergieversorgungsvorrichtung eine Ladefunktion und/oder einen externen Lader zum elektrischen Laden der Energiespeicher.

In einer weiteren vorteilhaften Ausführungsform der Messanordnung weist die Messanordnung eine Kommunikationsschnittstelle, insbesondere eine LIN-Bus-Schnittstelle, zum Ausgeben von elektrischen Messgrößen und/oder Parametern oder zum Empfang von Parametern und/oder Steuerbefehlen auf. Damit wird der Vorteil erreicht, dass eine effiziente Kommunikation zwischen der Messanordnung und einer an die Messanordnung angeschlossenen Vorrichtung erfolgen kann. Bei der Vorrichtung kann es sich beispielsweise um eine Hilfsenergieversorgungsvorrichtung handeln.

Die Kommunikationsschnittstelle kann mit einer Kommunikationsleitung in der Messeinrichtung verbunden sein. Ferner können die Prozessoreinrichtung und/oder die Messeinheiten der Messeinrichtung und/oder die Energiespeicher der Energiespeicheranordnung an die Kommunikationsleitung angeschlossen sein. Auf diese Art und Weise können über die Kommunikationsleitung die von der Prozessoreinrichtung erfassten Messgrößen an die an die Kommunikationsschnittstelle angeschlossene Vorrichtung übermittelt werden, oder Steuerbefehle, beispielsweise Befehle zum Öffnen oder Schließen der steuerbaren Schalter, von der an die Kommunikationsschnittstelle angeschlossenen Vorrichtung an die Prozessoreinrichtung übermittelt werden. Zudem können Betriebsparameter der Energiespeicher über die Kommunikationsleitung an die Prozessoreinrichtung oder an die an die Kommunikationsschnittstelle angeschlossene Vorrichtung übermittelt werden.

Gemäß einem zweiten Aspekt der Erfindung wird die Aufgabe durch eine Hilfsenergieversorgungsvorrichtung zur netzunabhängigen Bereitstellung elektrischer Energie gelöst, wobei die erfindungsgemäße Messanordnung in der Hilfsenergieversorgungsvorrichtung integriert ist. Dadurch wird der Vorteil erreicht, dass eine Hilfsenergieversorgungsvorrichtung mit hoher Zuverlässigkeit geschaffen werden kann, welche ohne extern angeschlossene Energiespeicher genutzt werden kann.

Ausführungsbeispiele der Erfindung sind in den Zeichnungen dargestellt und werden im Folgenden näher beschrieben.

Es zeigen:
- Fig. 1: eine schematische Darstellung einer Messanordnung;
- Fig. 2: eine schematische Darstellung einer Parallelschaltung zweier Energiespeicher;
- Fig. 3: eine schematische Darstellung einer Schaltungsanordnung;
- Fig. 4: eine schematische Darstellung einer Messanordnung;
- Fig. 5a: eine schematische Darstellung der Polaritäten der elektrischen Messgrößen mehrerer Energiespeicher; und
- Fig. 5b: eine schematische Darstellung der Polaritäten der elektrischen Messgrößen mehrerer Energiespeicher.

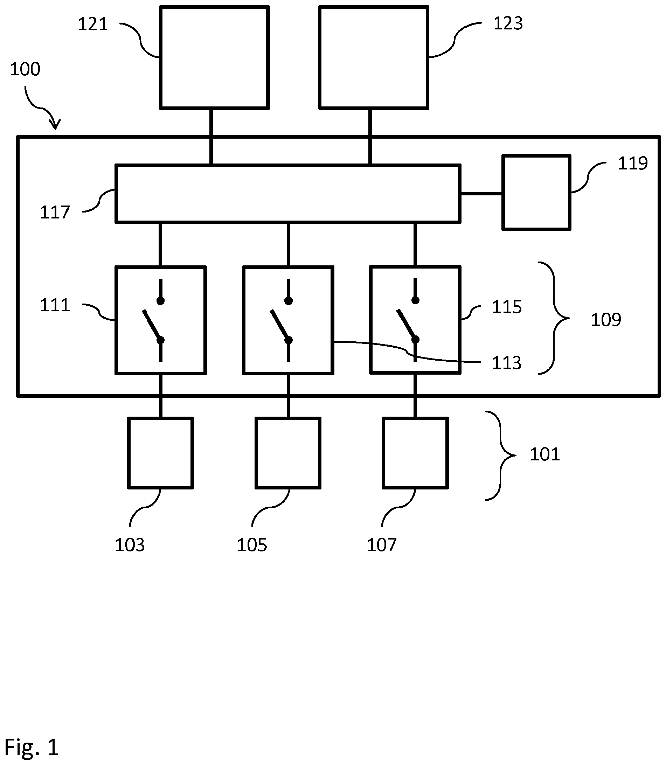

Fig. 1 zeigt eine schematische Darstellung einer Messanordnung 100. Die Messanordnung 100 weist eine Messeinrichtung 117, eine Schaltungsanordnung 109 und eine Prozessoreinrichtung 119 auf, wobei an die Messanordnung 100 eine Energiespeicheranordnung 101, eine Hilfsenergieversorgungsvorrichtung 121 und ein externer Lader 123 angeschlossen sind. Die Schaltungsanordnung 109 umfasst einem ersten steuerbaren Schalter 111 und zwei weitere steuerbare Schalter 113, 115, an welche ein erster Energiespeicher 103 und zwei weitere Energiespeicher 105, 107 angeschlossen sind.

Die Messanordnung 100 zum Erkennen einer Fehlfunktion in der Energiespeicheranordnung 101 mit dem ersten Energiespeicher 103 und mit zumindest einem weiteren Energiespeicher 105, 107 umfasst die Messeinrichtung 117, welche ausgebildet ist, eine elektrische Messgröße des ersten Energiespeichers 103 und eine elektrische Messgröße des weiteren Energiespeichers 105, 107 der Mehrzahl der Energiespeicher zu messen, die Schaltungsanordnung 109 mit einem ersten steuerbaren Schalter 111 zum elektrischen Verbinden des ersten Energiespeichers 103 mit der Messeinrichtung 117, und mit einem weiteren steuerbaren Schalter 113, 115 zum elektrischen Verbinden des weiteren Energiespeichers 105, 107 mit der Messeinrichtung, die Prozessoreinrichtung 119 zur Steuerung der steuerbaren Schalter der Schaltungsanordnung 109. Die Prozessoreinrichtung 119 ist ausgebildet, zur Erfassung der elektrischen Messgröße des ersten Energiespeichers 103 den ersten Schalter 111 geschlossen zu halten und den weiteren Schalter 113, 115 zu öffnen, um den weiteren Energiespeicher 105, 107 von der Messeinrichtung 117 abzutrennen, und zur Erfassung der elektrischen Messgröße des weiteren Energiespeichers 105, 107 den weiteren Schalter 113, 115 geschlossen zu halten und den ersten Schalter 111 zu öffnen, um den ersten Energiespeicher 103 von der Messeinrichtung 117 abzutrennen. Hierdurch kann die elektrische Messgröße eines jeden Energiespeichers einer Energiespeicheranordnung 101 effizient und unbeeinflusst von anderen Energiespeichern der Energiespeicheranordnung 101 erfasst werden kann.

Die Messanordnung 100 kann als abgeschlossenes Modul vorliegen, welches beispielsweise ein Gehäuse umfasst, in dem alle Komponenten der Messanordnung 100 angeordnet sind. Dieses Modul kann elektrische Anschlüsse für eine externe Energiespeicheranordnung 101 vorsehen. Ferner kann die Messanordnung 100 zusammen mit der Energiespeicheranordnung 101 ein abgeschlossenes Bauteil bilden, in welchem beispielsweise die Komponenten der Messanordnung 100 und die Energiespeicheranordnung 101 in einem gemeinsamen Gehäuse angeordnet sind.

Bei den Energiespeichern kann es sich um Akkumulatoren, beispielsweise Lithium-Ionen-Akkumulatoren, Lithium-Polymer-Akkumulatoren oder Bleiakkumulatoren, handeln, welche eine Akkumulator-Spannung von beispielsweise 12 oder 24 Volt aufweisen können. Dabei können die Energiespeicher, die in der Energiespeicheranordnung 101 miteinander elektrisch verbunden sind, gleichen Typs sein und eine gleiche Spannung und eine gleiche Säuredichte aufweisen.

Die steuerbaren Schalter der Schaltungsanordnung 109 können Transistorschalter, insbesondere MOSFET-Schalter, sein. Insbesondere kann jeder steuerbare Schalter aus einer elektrischen Schaltung bestehen, welche zwei in Reihe geschaltete MOSFET-Schalter umfasst, deren Source-Anschlüsse elektrisch verbunden sind. Zusätzlich kann zur Spannungsbegrenzung eine Zener-Diode zwischen die Source- und die Gate-Anschlüsse der MOSFET-Schalter geschalten werden.

Die Prozessoreinrichtung 119 kann ein Mikrocontroller sein, wobei der Mikrocontroller einen Prozessor und/oder einen Speicher umfassen kann. Die Prozessoreinrichtung 119 kann mit der Messeinrichtung 117 zum Empfang der gemessenen elektrischen Messgrößen elektrisch verbunden sein. Ferner kann die Prozessoreinrichtung 119 derart konfiguriert sein, dass sie Parameterwerte aus den empfangenen elektrischen Messgrößen berechnet. Handelt es sich bei den steuerbaren Schaltern um Transistorschalter, so kann die Prozessoreinrichtung 119 zur Steuerung der steuerbaren Schalter mit den Gate-Elektroden der Transistorschalter elektrisch verbunden sein und diese durch das Anlegen einer Gate-Spannung elektrisch steuern. Um bei der Ansteuerung der Gate-Elektroden der Transistorschalter eine ausreichend hohen Gate-Spannung bereitzustellen können Gleichspannungswandler, beispielsweise Hochsetzsteller oder Ladungspumpen zwischen die Prozessoreinrichtung 119 und die Gate-Elektroden der Transistorschalter geschaltet sein.

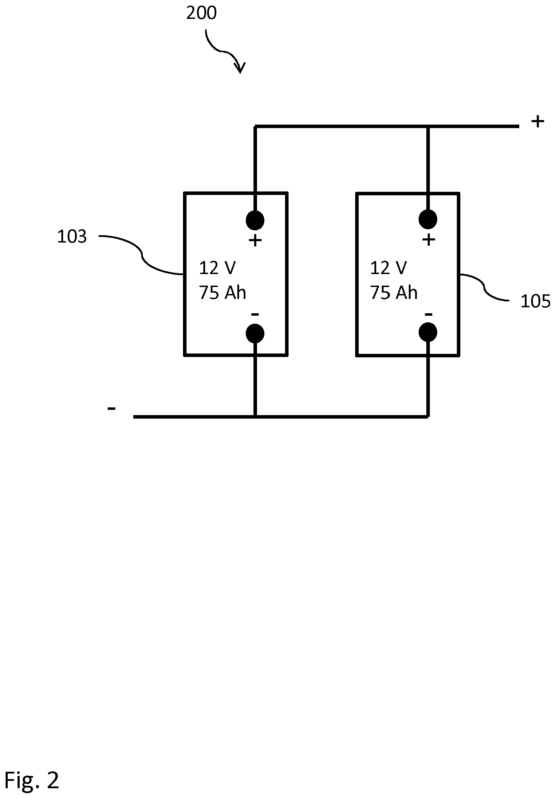

Fig. 2 zeigt eine schematische Darstellung einer Parallelschaltung 200 eines ersten Energiespeichers 103 und eines weiteren Energiespeichers 105.

Die Parallelschaltung 200 des ersten Energiespeichers 103 und des weiteren Energiespeichers 105 kann gebildet werden, indem die die Pluspole der Energiespeicher und die Minuspole der Energiespeicher miteinander elektrisch verbunden werden. Gemäß einer weiteren Ausführungsform kann es sich bei dem so verbundenen Energiespeichern um Energiespeicher des gleichen Typs, beispielsweise Akkumulatoren mit gleicher Spannung und gleicher Säuredichte, handeln.

In Fig. 2 weisen beispielsweise der erste Energiespeicher 103 und der weitere Energiespeicher 105 eine Spannung von jeweils 12 V und eine Ladekapazität von jeweils 75 Ah auf. Durch die Parallelschaltung 200 summiert sich die Ladekapazität des ersten Energiespeichers 103 und des weiteren Energiespeichers 105, während die Spannung der Parallelschaltung 200 der Spannung der einzelnen Energiespeicher entspricht. Die resultierende Parallelschaltung 200 der Energiespeicher in Fig. 2 weist eine Spannung von 12 V und eine Ladekapazität von 150 Ah auf. Auf diese Art und Weise kann eine Parallelschaltung 200 aus einer beliebigen Anzahl von einzelnen Energiespeichern mit jeweils gleicher Spannung geschaffen werden, wobei die resultierende Spannung der Parallelschaltung 200 der Spannungen der einzelnen Energiespeicher und die Ladekapazität der Parallelschaltung 200 der Summe der Ladekapazitäten der einzelnen Energiespeicher entspricht. Gemäß einer weiteren Ausführungsform kann es sich bei dem ersten Energiespeicher 103 und dem weiteren Energiespeicher 105 um Lithium-Ionen-Akkumulatoren, Lithium-Polymer-Akkumulatoren oder Bleiakkumulatoren handeln.

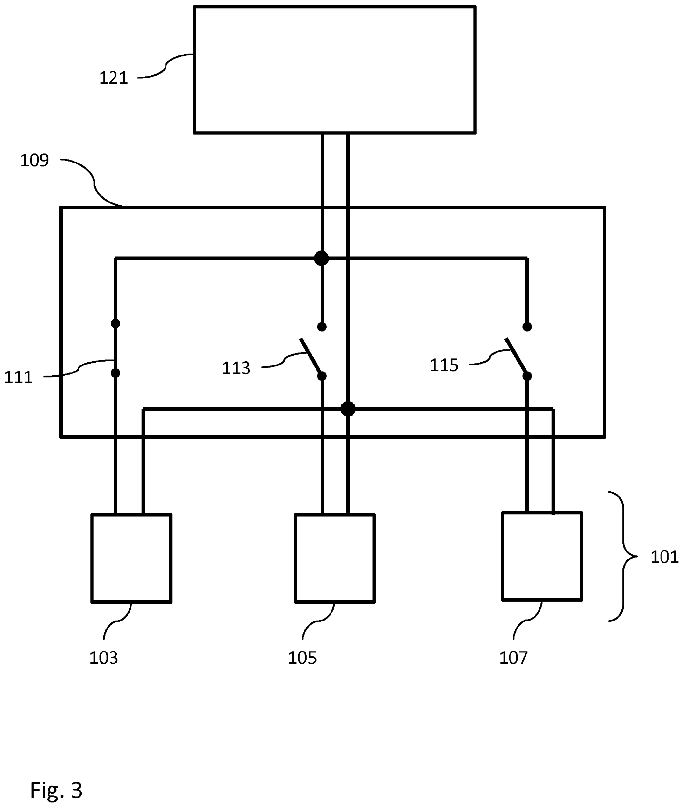

Fig. 3 zeigt eine schematische Darstellung einer Schaltungsanordnung 109 bestehend aus einem ersten steuerbaren Schalter 111 und zwei weiteren steuerbaren Schaltern 113, 115, an welche eine Energiespeicheranordnung 101 bestehend aus einem ersten Energiespeicher 103 und zwei weiteren Energiespeichern 105, 107 angeschlossen ist. Ferner ist eine Hilfsenergieversorgungsvorrichtung 121 an die Schaltungsanordnung 109 angeschlossen.

Der erste steuerbare Schalter 111 oder die weiteren steuerbaren Schalter 113, 115 der Schaltungsanordnung 109 können geöffnet werden um die Verbindung des ersten Energiespeichers 103 oder der weiteren Energiespeicher 105, 107 mit der Hilfsenergieversorgungsvorrichtung 121 und/oder der Messeinrichtung 117 zu unterbrechen. In Fig. 3 ist der erste steuerbare Schalter 111 geschlossen und sind die weiteren steuerbaren Schalter 113, 115 geöffnet. Die Messeinrichtung 117 und die Prozessoreinrichtung 119 sind in Fig. 3 nicht eingezeichnet.

Gemäß einer weiteren Ausführungsform kann durch die steuerbaren Schalter eine Abschaltmöglichkeit von defekten Energiespeichern der Energiespeicheranordnung 101 geschaffen werden. Bei der Feststellung eines fehlerhaften Energiespeichers kann der mit dem fehlerhaften Energiespeicher verbundene steuerbare Schalter dauerhaft geöffnet werden, und somit die Verbindung des fehlerhaften Energiespeichers mit der Hilfsenergieversorgungsvorrichtung 121 und/oder der Messeinrichtung 117 und/oder den restlichen Energiespeichern der Energiespeicheranordnung 101 dauerhaft unterbrochen werden. Durch das Abschalten eines fehlerhaften Energiespeichers kann eine negative Beeinflussung der restlichen Energiespeicher, beispielsweise eine Entladung der restlichen Energiespeicher durch den fehlerhaften Energiespeicher, vermieden werden.

Gemäß einer weiteren Ausführungsform kann eine zyklische Prüfung der einzelnen Energiespeicher 103, 105, 107 der Energiespeicheranordnung 101 erfolgen. Diese zyklische Prüfung kann in zeitlich aufeinanderfolgenden Messintervallen erfolgen, wobei in jedem Messintervall ein steuerbarer Schalter, welcher mit einem zu prüfenden Energiespeicher verbunden ist, geschlossen wird und alle anderen steuerbaren Schalter der Schaltungsanordnung 109 geöffnet werden. Somit kann in dem Messintervall die elektrische Messgröße des zu prüfenden Energiespeichers unbeeinflusst von den restlichen Energiespeichern der Energiespeicheranordnung 101 erfolgen. Fig. 3 zeigt beispielsweise die Stellung der Schalter in einem Messintervall, in dem der erste Energiespeicher 103 geprüft wird und zu diesem Zweck nur der erste steuerbare Schalter 111 geschlossen ist und die weiteren steuerbaren Schalter 113, 115 geöffnet sind. Gemäß einer weiteren Ausführungsform kann diese zyklische Prüfung der Energiespeicher in zeitlich aufeinanderfolgenden Messintervallen in einem Testmodus der Messanordnung 100 erfolgen, welcher sich von dem Betriebsmodus, in dem alle steuerbaren Schalter geschlossen sind, unterscheidet.

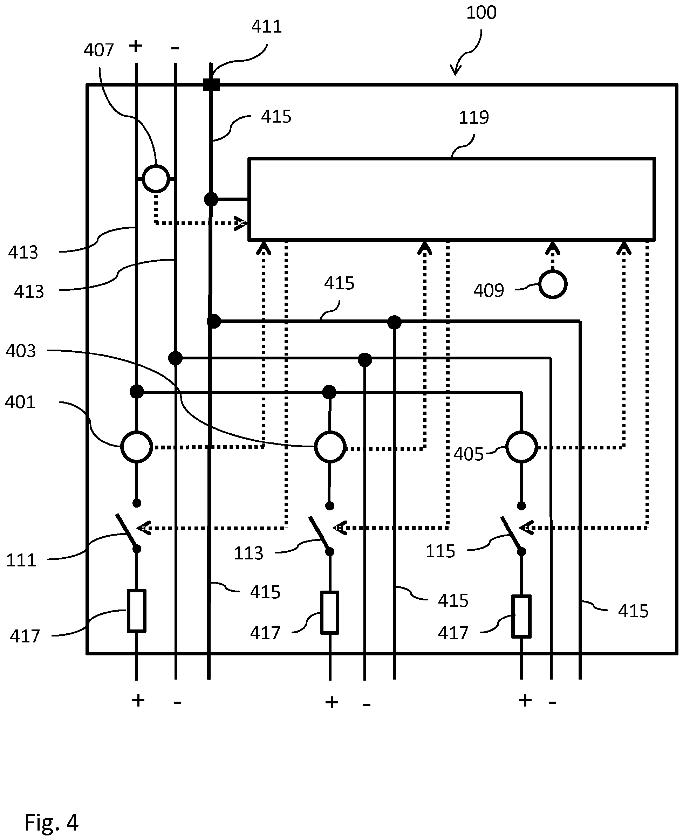

Fig. 4 zeigt eine schematische Darstellung einer Messanordnung 100, wobei einzelne Messeinheiten der Messeinrichtung 117 dargestellt sind. Bei den Messeinheiten handelt es sich um eine mit dem ersten steuerbaren Schalter 111 verbundene erste Messeinheit 401, zwei weiteren Messeinheiten 403, 405, welche jeweils mit einem weiteren steuerbaren Schalter 113, 115 verbunden sind, sowie eine gemeinsame Messeinheit 407 und eine Umgebungsmesseinheit 409. Ferner weist die Messordnung 100 eine elektrische Leitungsanordnung 413 auf, welche die Energiespeicher in der Messanordnung 100 parallel schalten, und eine Kommunikationsleitung 415, welche an die Energiespeicher, die Prozessoreinrichtung 119 und an eine Kommunikationsschnittstelle 411 angeschlossen ist.

Die erste Messeinheit 401 und die weiteren Messeinheiten 403, 405 können eine elektrische Messgröße des ersten Energiespeichers 103, beziehungsweise eine elektrische Messgröße der weiteren Energiespeicher 105, 107 erfassen. Bei diesen elektrischen Messgrößen kann es sich um einen Innenwiderstande, einer Spannung, oder einen Strom handeln. Gemäß einer Ausführungsform können die elektrischen Messgrößen Lade- oder Entladeströme des ersten Energiespeichers 103 und der weiteren Energiespeicher 105, 107 sein, wobei die Stromrichtung die Polarität der elektrischen Messgrößen angibt. Die gemeinsame Messeinheit 407 kann eine gemeinsame elektrische Messgröße des ersten und der weiteren Energiespeicher erfassen. Bei der gemeinsamen elektrischen Messgröße kann es sich ebenfalls um einen Innenwiderstandes, eine Spannung, oder einen Strom handeln. Ferner kann die gemeinsame elektrische Messgröße ein gemeinsamer Lade- oder Entladestrom des ersten Energiespeichers 103 und der weiteren Energiespeicher 105, 107 sein, wobei die Stromrichtung die gemeinsame Polarität der gemeinsamen elektrischen Messgröße angibt.

Gemäß einer weiteren Ausführungsform sind die erste Messeinheit 401, die weiteren Messeinheiten 403, 405 und die gemeinsame Messeinheit 407 an der Prozessoreinrichtung 119 elektrisch angeschlossen. Die in den Messeinheiten ermittelten elektrischen Messgrößen können so an die Prozessoreinrichtung 119 übermittelt und in der Prozessoreinrichtung 119 ausgewertet werden. Diese Auswertung kann aus einem Vergleich der elektrischen Messgrößen untereinander oder einen Vergleich der elektrischen Messgrößen mit elektrischen Referenzgrößen bestehen. Gemäß einer weiteren Ausführungsform ist die Umgebungsmesseinheit 409 eine Temperaturmesseinheit, welche ebenfalls an die Prozessoreinrichtung 119 elektrisch angeschlossen ist. Die gemessenen Temperaturwerte können in der Prozessoreinrichtung 119 ausgewertet werden. Beispielsweise kann bei einem starken Anstieg der Temperatur auf einen defekten Energiespeicher geschlossen werden.

Gemäß einer weiteren Ausführungsform ist an die Kommunikationsschnittstelle 411 eine Kommunikationsleitung 415 angeschlossen. Diese Kommunikationsleitung 415 verbindet die Kommunikationsschnittstelle 411 mit der Prozessoreinrichtung 119 und/oder den Energiespeichern der Energiespeicheranordnung 101. Ist an die Kommunikationsschnittstelle 411 ferner eine Vorrichtung, beispielsweise eine Hilfsenergieversorgungsvorrichtung 121, angeschlossen, so können Parameterwerte und Messgrößen von der Prozessoreinrichtung 119 oder den Energiespeichern 103, 105, 107 an die angeschlossene Vorrichtung übermittelt werden, oder Befehle, beispielsweise Steuerbefehle zum Öffnen oder Schließen der steuerbaren Schalter, von der angeschlossenen Vorrichtung an die Prozessoreinrichtung 119 übermittelt werden.

Gemäß einer weiteren Ausführungsform ist die Kommunikationsschnittstelle 411 eine LIN-Bus Schnittstelle und erflogt die Kommunikation über die Kommunikationsleitung 415 gemäß einem LIN-Bus-Standard. In diesem LIN-Bus-System kann die Hilfsenergieversorgungsvorrichtung 121 als Master und können die Prozessoreinrichtung 119 sowie die Energiespeicher als Slaves eingerichtet sein. Zur Kommunikation über den LIN-Bus kann jeder an die Kommunikationsleitung 415 angeschlossenen Komponente eine eindeutige Kommunikationsadresse zugeordnet sein.

Gemäß einer weiteren Ausführungsform sind die steuerbaren Schalter 111, 113, 115 der Schaltungsanordnung 109 über elektrische Widerstände 417 mit den Energiespeichern 103, 105, 107 der Energiespeicheranordnung 101 elektrisch verbunden. Diese elektrischen Widerstände 417 können bei der Messung der Innenwiderstandes oder der Ladebeziehungsweise Entladeströme der Energiespeicher 103, 105, 107 verwendet werden.

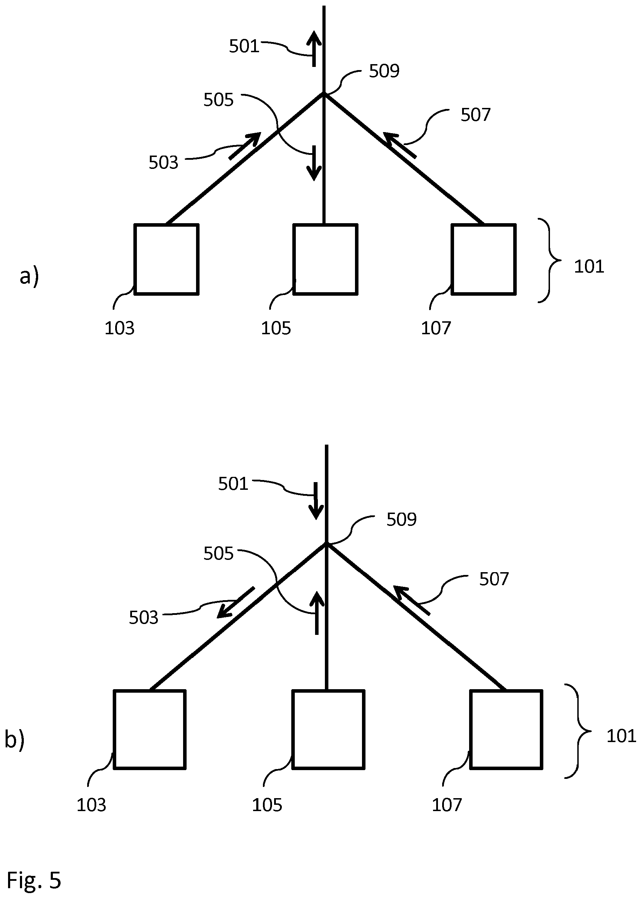

Fig. 5a und Fig.5b zeigen schematische Darstellungen der Polaritäten von elektrischen Messgrößen in einer Energiespeicheranordnung 101, bestehend aus einem ersten Energiespeicher 103 und zwei weiteren Energiespeichern 105, 107, welche an einem Verbindungspunkt 509 elektrisch verbunden sind.

Die elektrische Messgröße bezieht sich in Fig. 5a und Fig.5b auf den Lade- oder Entladestrom des ersten Energiespeichers 103, die Lade- oder Entladeströme der weiteren Energiespeicher 105, 107 sowie den gemeinsamen Lade- oder Entladestrom der Energiespeicheranordnung 101. Die Pfeile in Fig. 5a und Fig.5b markieren die Stromrichtung 503 des Lade- oder Entladestroms des ersten Energiespeichers 103, die Stromrichtungen 505, 507 der Lade- oder Entladeströme der weiteren Energiespeicher 105, 107 sowie die gemeinsame Stromrichtung 501 der Lade- oder Entladeströme der Energiespeicheranordnung 101.

In Fig. 5a zeigen die gemeinsame Stromrichtung 501 der Energiespeicheranordnung 101, die Stromrichtung 503 des ersten Energiespeichers 103 und die Stromrichtung 507 eines weiteren Energiespeichers 107 in Entladerichtung. Die Stromrichtung 505 eines zusätzlichen weiteren Energiespeichers 105 zeigt jedoch in Laderichtung. Diese Abweichung kann auf einen Defekt des weiteren Energiespeichers 105 hinweisen. Der fehlerhafte weitere Energiespeicher 105 in Fig. 5a wird nicht entladen und bezieht stattdessen einen Ladestrom, welcher von dem ersten Energiespeicher 103 und/oder dem anderen weiteren Energiespeicher 107 bezogen wird. In dieser Anordnung kann der fehlerhafte weitere Energiereicher 105 über die Messung der Polaritäten des Lade- oder Entladestroms des ersten Energiespeichers 103, der Polaritäten der Lade- oder Entladeströme der weiteren Energiespeicher 105, 107, sowie der Polarität des gemeinsamen Lade- oder Entladestroms der Energiespeicheranordnung 101 identifiziert werden.

In Fig. 5b zeigt die gemeinsame Stromrichtung 501 der Energiespeicheranordnung 101, sowie die Stromrichtung 503 des ersten Energiespeichers 103 in Laderichtung. Die Stromrichtung 505, 507 der weiteren Energiespeicher 105, 107 zeigen jedoch in Entladerichtung. Diese Abweichung kann auf einen Defekt des ersten Energiespeichers 103 hinweisen. Die weiteren Energiespeicher 105, 107 in Fig. 5b werden entladen und stellen dem ersten Energiespeicher 103 einen zusätzlichen Ladestrom zur Verfügung. Dies kann durch eine Fehlfunktion des ersten Energiespeichers 103 verursacht sein, welcher aufgrund eines Defektes einen zusätzlichen Ladestrom von den weiteren Energiespeicher 105, 107 bezieht. In dieser Anordnung kann der fehlerhafte erste Energiereicher 103 über die Messung der Polaritäten des Lade- oder Entladestroms des ersten Energiespeichers 103, der Polaritäten der Lade- oder Entladeströme der weiteren Energiespeicher 105, 107, sowie der Polarität des gemeinsamen Lade- oder Entladestroms der Energiespeicher identifiziert werden.

Alle in Verbindung mit einzelnen Ausführungsformen der Erfindung erläuterten und gezeigten Merkmale können in unterschiedlicher Kombination in dem erfindungsgemäßen Gegenstand vorgesehen sein, um gleichzeitig deren vorteilhafte Wirkungen zu realisieren.

### BEZUGSZEICHENLISTE

- 100: Messanordnung
- 101: Energiespeicheranordnung
- 103: erster Energiespeicher
- 105: weiterer Energiespeicher
- 107: weiterer Energiespeicher
- 109: Schaltungsanordnung
- 111: erster steuerbarer Schalter
- 113: weiterer steuerbarer Schalter
- 115: weiterer steuerbarer Schalter
- 117: Messeinrichtung
- 119: Prozessoreinrichtung
- 121: Hilfsenergieversorgungsvorrichtung
- 123: externer Lader

- 200: Parallelschaltung

- 401: erste Messeinheit
- 403: weitere Messeinheit
- 405: weitere Messeinheit
- 407: gemeinsame Messeinheit
- 409: Umgebungsmesseinheit
- 411: Kommunikationsschnittstelle
- 413: elektrische Leitungsanordnung
- 415: Kommunikationsleitung
- 417: elektrischer Widerstand

- 501: gemeinsame Stromrichtung der Energiespeicheranordnung
- 503: Stromrichtung des ersten Energiespeichers
- 505: Stromrichtung eines weiteren Energiespeichers
- 507: Stromrichtung eines weiteren Energiespeichers
- 509: Verbindungspunkt

## Patentansprüche

1. Messanordnung (100) zum Erkennen einer Fehlfunktion in einer Energiespeicheranordnung (101) mit einem ersten Energiespeicher (103) und mit zumindest einem weiteren Energiespeicher (105, 107), mit:
einer Messeinrichtung (117), welche ausgebildet ist, eine elektrische Messgröße des ersten Energiespeichers (103) und eine elektrische Messgröße des weiteren Energiespeichers (105, 107) der Mehrzahl der Energiespeicher zu messen;
einer Schaltungsanordnung (109) mit einem ersten steuerbaren Schalter (111) zum elektrischen Verbinden des ersten Energiespeichers (103) mit der Messeinrichtung (117), und mit einem weiteren steuerbaren Schalter (113, 115) zum elektrischen Verbinden des weiteren Energiespeichers (105, 107) mit der Messeinrichtung (117);
einer Prozessoreinrichtung (119) zur Steuerung der steuerbaren Schalter (111, 113, 115) der Schaltungsanordnung (109), wobei die Prozessoreinrichtung (119) ausgebildet ist, zur Erfassung der elektrischen Messgröße des ersten Energiespeichers (103) den ersten Schalter (111) geschlossen zu halten und den weiteren Schalter (113, 115) zu öffnen, um den weiteren Energiespeicher (105, 107) von der Messeinrichtung (117) abzutrennen, und zur Erfassung der elektrischen Messgröße des weiteren Energiespeichers (105, 107) den weiteren Schalter (113, 115) geschlossen zu halten und den ersten Schalter (111) zu öffnen, um den ersten Energiespeicher (103) von der Messeinrichtung (117) abzutrennen,
**dadurch gekennzeichnet, dass**
die Messeinrichtung (117) eine mit dem ersten steuerbaren Schalter (111) verbundene erste Messeinheit (401) zur Messung der elektrischen Messgröße des ersten Energiespeichers (103), insbesondere eines Innenwiderstandes, einer Spannung, oder eines Stroms, aufweist, und wobei die Messeinrichtung (117) eine mit dem weiteren steuerbaren Schalter (113, 115) verbundene weitere Messeinheit (403, 405) zur Messung der elektrischen Messgröße des weiteren Energiespeichers (105, 107), insbesondere eines Innenwiderstandes, einer Spannung, oder eines Stroms, aufweist, und wobei die Messeinrichtung (117) eine mit dem ersten steuerbaren Schalter (111) und weiteren steuerbaren Schalter (113, 115) verbundene gemeinsame Messeinheit (407) zur Messung einer gemeinsamen elektrischen Messgröße, insbesondere eines Innenwiderstandes, einer Spannung, oder eines Stroms, des ersten Energiespeichers (103) und des weiteren Energiespeichers (105, 107) aufweist.

2. Messanordnung (100) nach Anspruch 1, wobei die Schaltungsanordnung (109) ausgebildet ist, den ersten Energiespeicher (103) und den weiteren Energiespeicher (105, 107) im Betrieb der Energiespeicher (103, 105, 107) parallelzuschalten.

3. Messanordnung (100) nach Anspruch 1 oder 2, welche in einem Testmodus und in einem Betriebsmodus betreibbar ist, wobei die elektrische Messgröße des ersten Energiespeichers (103) und die elektrische Messgröße des weiteren Energiespeichers (105, 107) in dem Testmodus erfasst werden, und wobei die Schaltungsanordnung (109) in dem Betriebsmodus ausgebildet ist, den ersten Energiespeicher (103) und den weiteren Energiespeicher (105, 107) parallelzuschalten.

4. Messanordnung (100) nach einem der vorstehenden Ansprüche, wobei die Messeinrichtung (117) ausgebildet ist, die elektrische Messgröße des ersten Energiespeichers (103) und die elektrische Messgröße des weiteren Energiespeichers (105, 107) in zeitlich aufeinanderfolgenden Messintervallen zu erfassen, wobei innerhalb eines Messintervalls genau nur ein Schalter (111, 113, 115) der Schaltungsanordnung (109) geschlossen ist und alle anderen Schalter (111, 113, 115) der Schaltungsanordnung (109) geöffnet sind.

5. Messanordnung (100) nach Anspruch 4, wobei die Prozessoreinrichtung (119) ausgebildet ist, innerhalb eines ersten Messintervalls nur den ersten Schalter (111) geschlossen zu halten und den weiteren Schalter (113, 115) zu öffnen, und innerhalb eines weiteren Messintervalls nur den weiteren Schalter (113, 115) geschlossen zu halten und den ersten Schalter zu (111) öffnen.

6. Messanordnung (100) nach einem der vorstehenden Ansprüche, wobei die Prozessoreinrichtung (119) ausgebildet ist, die gemessenen elektrischen Messgrößen auszuwerten, insbesondere mit elektrischen Referenzgrößen zu vergleichen, um eine Fehlfunktion des ersten Energiespeichers (103) oder des weiteren Energiespeichers (105, 107) zu erfassen.

7. Messanordnung (100) nach Anspruch 6, wobei Prozessoreinrichtung (119) ausgebildet ist, bei erfasster Fehlfunktion des ersten Energiespeichers (103) den ersten steuerbaren Schalter (111) dauerhaft zu öffnen, um den ersten Energiespeicher (103) abzutrennen, oder bei erfasster Fehlfunktion des weiteren Energiespeichers (105, 107) den weiteren steuerbaren Schalter (113, 115) dauerhaft zu öffnen, um den weiteren Energiespeicher (105, 107) abzutrennen.

8. Messanordnung (100) nach einem der vorstehenden Ansprüche, wobei die Schaltungsanordnung (109) ausgebildet ist, den ersten elektrischen Energiespeicher (103) und den weiteren elektrischen Energiespeicher (105, 107) parallel zu schalten, und wobei die Messeinrichtung ausgebildet ist, eine Polarität der elektrischen Messgröße des ersten Energiespeichers (103) und eine Polarität einer weiteren elektrischen Messgröße in der Energiespeicheranordnung (101) zu erfassen, wobei die Prozessoreinrichtung (119) ausgebildet ist, die Fehlfunktion der Energiespeicheranordnung (101) durch einen Vergleich der Polarität der elektrischen Messgröße des ersten Energiespeichers (103) und der Polarität der weiteren elektrischen Messgröße zu erkennen, wobei es sich bei der elektrischen Messgröße und der weiteren elektrischen Messgröße jeweils um eine Spannung oder einen Strom handelt.

9. Messanordnung (100) nach Anspruch 8, wobei die Prozessoreinrichtung (119) ausgebildet ist, die Fehlfunktion eines Energiespeichers (103, 105, 107) der Energiespeicheranordnung (101) zu erkennen, falls die Polarität der elektrischen Messgröße des ersten Energiespeichers (103) und die Polarität der weiteren elektrischen Messgröße unterschiedlich sind.

10. Messanordnung (100) nach Anspruch 8 oder 9, wobei die Messeinrichtung (117) ausgebildet ist, die Polarität der elektrischen Messgröße des ersten Energiespeichers (103) und die Polarität der weiteren elektrischen Messgröße durch Erfassung einer elektrischen Richtung der elektrischen Messgröße des ersten Energiespeichers (103) und der weiteren elektrischen Messgröße zu erfassen.

11. Messanordnung (100) nach einem der Ansprüche 8 bis 10, wobei eine erste Messeinheit (401) zur Erfassung der Polarität der elektrischen Messgröße des ersten Energiespeichers (103) ausgebildet ist, und wobei eine weitere Messeinheit (403, 405) zur Erfassung der Polarität der weiteren elektrischen Messgröße ausgebildet ist.

12. Messanordnung (100) nach Anspruch 11, wobei die Messeinrichtung (117) eine gemeinsame Messeinheit (407) zur Erfassung der Polarität der elektrischen Messgröße an dem Verbindungspunkt (509) des ersten Energiespeichers (103) und des weiteren Energiespeichers (105, 107) aufweist, um eine gemeinsame Polarität zu erhalten, und wobei die Prozessoreinrichtung (119) ausgebildet ist, die Fehlfunktion der Energiespeicheranordnung (101) durch einen Vergleich der Polarität der elektrischen Messgröße des ersten Energiespeichers (103) oder der Polarität der weiteren elektrischen Messgröße mit der gemeinsamen Polarität zu erkennen.

13. Messanordnung (100) nach einem der vorstehenden Ansprüche, wobei die Messanordnung (100) einen Verbindungsanschluss zum Verbinden der Schaltungsanordnung (109) mit einer Hilfsenergieversorgungsvorrichtung (121), insbesondere einer unterbrechungsfreien Spannungsversorgung aufweist, um die elektrischen Energiespeicher für die Hilfsenergieversorgung bereitzustellen.

14. Hilfsenergieversorgungsvorrichtung (121) zur netzunabhängigen Bereitstellung elektrischer Energie, wobei eine Messanordnung (100) nach einem der vorstehenden Ansprüche in der Hilfsenergieversorgungsvorrichtung (121) integriert ist.

## Claims

1. A measuring arrangement (100) for identifying a malfunction in an energy accumulator arrangement (101) comprising a first energy accumulator (103) and at least one further energy accumulator (105, 107), the measuring arrangement (100) comprising:
a measuring device (117) which is configured to measure an electrical measurement of the first energy accumulator (103) and an electrical measurement of the further energy accumulator (105, 107) of the plurality of energy accumulators;
a circuit arrangement (109) comprising a first controllable switch (111) for electrically connecting the first energy accumulator (103) to the measuring device (117), and a further controllable switch (113, 115) for electrically connecting the further energy accumulator (105, 107) to the measuring device (117);
a processor device (119) for controlling the controllable switches (111, 113, 115) of the circuit arrangement (109), wherein the processor device (119) is configured to close the first switch (111) to identify the electrical measurement of the first energy accumulator (103) and to open the further switch (113, 115) in order to disconnect the further energy accumulator (105, 107) from the measuring device (117), and to keep the further switch (113, 115) closed in order to identify the electrical measurement of the further energy accumulator (105, 107) and to open the first switch (111) in order to disconnect the first energy accumulator (103) from the measuring device (117),
**characterized in that**
the measuring device (117) comprises a first measuring unit (401) connected to the first controllable switch (111) for measuring the electrical measurement of the first energy accumulator (103), in particular an internal resistance, a voltage or a current, and wherein the measuring device (117) comprises a further measuring unit (403, 405) connected to the further controllable switch (113, 115) for measuring the electrical measurement of the further energy accumulator (105, 107), in particular an internal resistance, a voltage or a current, and wherein the measuring device (117) comprises a common measuring unit (407) connected to the first controllable switch (111) and the further controllable switch (113, 115) for measuring a common electrical measurement, in particular an internal resistance, a voltage, or a current, of the first energy accumulator (103) and the further energy accumulator (105, 107).

2. The measuring arrangement (100) according to claim 1, wherein the circuit arrangement (109) is configured to connect the first energy accumulator (103) and the further energy accumulator (105, 107) in parallel during operation of the energy accumulators (103, 105, 107).

3. The measuring arrangement (100) according to claim 1 or 2, which can be operated in a test mode and in an operating mode, wherein the electrical measurement of the first energy accumulator (103) and the electrical measurement of the further energy accumulator (105, 107) are identified in the test mode, and wherein the circuit arrangement (109) is configured to connect the first energy accumulator (103) and the further energy accumulator (105, 107) in parallel when being in the operating mode.

4. The measuring arrangement (100) according to one of the preceding claims, wherein the measuring device (117) is configured to identify the electrical measurement of the first energy accumulator (103) and the electrical measurement of the further energy accumulator (105, 107) in successive measurement intervals, wherein within a measuring interval only one switch (111, 113, 115) of the circuit arrangement (109) is closed and all other switches (111, 113, 115) of the circuit arrangement (109) are open.

5. The measuring arrangement (100) according to claim 4, wherein the processor device (119) is configured to keep only the first switch (111) closed and to open the further switch (113, 115) within a first measuring interval, and to keep only the further switch (113, 115) closed and to open the first switch (111) within a further measuring interval.

6. The measuring arrangement (100) according to one of the preceding claims, wherein the processor device (119) is configured to evaluate, in particular compare with electrical reference variables, the measured electrical measurements in order to identify a malfunction of the first energy accumulator (103) or of the further energy accumulator (105, 107).

7. The measuring arrangement (100) according to claim 6, wherein the processor device (119) is configured to permanently open the first controllable switch (111), if a malfunction of the first energy accumulator (103) is identified, in order to disconnect the first energy accumulator (103), or to permanently open the further controllable switch (113, 115), if a malfunction of the further energy accumulator (105, 107) is identified, in order to disconnect the further energy accumulator (105, 107).

8. The measuring arrangement (100) according to one of the preceding claims, wherein the circuit arrangement (109) is configured to connect the first electrical energy accumulator (103) and the further electrical energy accumulator (105, 107) in parallel, and wherein the measuring device is configured to identify a polarity of the electrical measurement of the first energy accumulator (103) and a polarity of a further electrical measurement in the energy accumulator arrangement (101), wherein the processor device (119) is configured to identify the malfunction of the energy accumulator arrangement (101) by comparing the polarity of the electrical measurement of the first energy accumulator (103) and the polarity of the further electrical measurement, wherein the electrical measurement and the further electrical measurement is a voltage or a current respectively.

9. The measuring arrangement (100) according to claim 8, wherein the processor device (119) is configured to identify the malfunction of an energy accumulator (103, 105, 107) of the energy accumulator arrangement (101), if the polarity of the electrical measurement of the first energy accumulator (103) and the polarity of the further electrical measurement are different.

10. The measuring arrangement (100) according to claim 8 or 9, wherein the measuring device (117) is configured to identify the polarity of the electrical measurement of the first energy accumulator (103) and the polarity of the further electrical measurement by identifying an electrical direction of the electrical measurement of the first energy accumulator (103) and the other electrical measurement.

11. The measuring arrangement (100) according to one of claims 8 to 10, wherein a first measuring unit (401) is configured to identify the polarity of the electrical measurement of the first energy accumulator (103), and wherein a further measuring unit (403, 405) is configured to identify the polarity of the further electrical measurement.

12. The measuring arrangement (100) according to claim 11, wherein the measuring device (117) comprises a common measuring unit (407) for identifying the polarity of the electrical measurement at the connection point (509) of the first energy accumulator (103) and the further energy accumulator (105, 107) in order to obtain a common polarity, and wherein the processor device (119) is configured to identify the malfunction of the energy accumulator arrangement (101) by comparing the polarity of the electrical measurement of the first energy accumulator (103) or the polarity of the further electrical measurement with the common polarity.

13. The measuring arrangement (100) according to one of the preceding claims, wherein the measuring arrangement (100) comprises a connection terminal for connecting the circuit arrangement (109) to an auxiliary energy supply device (121), in particular an uninterruptible voltage supply, in order to provide the electrical energy accumulators for the auxiliary energy supply.

14. An auxiliary energy supply device (121) for providing electrical energy mains-independently, wherein a measuring arrangement (100) according to one of the preceding claims is integrated in the auxiliary energy supply device (121).

## Revendications

1. Agencement de mesure (100) permettant d'identifier un dysfonctionnement dans un agencement d'accumulateur d'énergie (101) doté d'un premier accumulateur d'énergie (103) et d'au moins un autre accumulateur d'énergie (105, 107), comprenant :
un dispositif de mesure (117) qui est réalisé pour mesurer une grandeur de mesure électrique du premier accumulateur d'énergie (103) et une grandeur de mesure électrique de l'autre accumulateur d'énergie (105, 107) de la pluralité des accumulateurs d'énergie ;
un agencement de circuit (109) doté d'un premier commutateur pouvant être commandé (111), destiné à relier électriquement le premier accumulateur d'énergie (103) au dispositif de mesure (117), et d'au moins un autre commutateur pouvant être commandé (113, 115), destiné à relier électriquement l'autre accumulateur d'énergie (105, 107) au dispositif de mesure (117) ;
un dispositif à processeur (119) destiné à commander le commutateur pouvant être commandé (111, 113, 115) de l'agencement de circuit (109), dans lequel, pour la détection de la grandeur de mesure électrique du premier accumulateur d'énergie (103), le dispositif à processeur (119) est réalisé pour maintenir fermé le premier commutateur (111) et pour ouvrir l'autre commutateur (113, 115) afin de déconnecter l'autre accumulateur d'énergie (105, 107) du dispositif de mesure (117), et pour la détection de la grandeur de mesure électrique de l'autre accumulateur d'énergie (105, 107), pour maintenir fermé l'autre commutateur (113, 115) et pour ouvrir le premier commutateur (111) afin de déconnecter le premier accumulateur d'énergie (103) du dispositif de mesure (117),
**caractérisé en ce que** le dispositif de mesure (117) présente une première unité de mesure (401), reliée au premier commutateur pouvant être commandé (111), destinée à mesurer la grandeur de mesure électrique du premier accumulateur d'énergie (103), en particulier une résistance interne, une tension ou un courant, et dans lequel le dispositif de mesure (117) présente une autre unité de mesure (403, 405) reliée à l'autre commutateur pouvant être commandé (113, 115), destinée à mesurer la grandeur de mesure électrique de l'autre accumulateur d'énergie (105, 107), en particulier une résistance interne, une tension ou un courant, et dans lequel le dispositif de mesure (117) présente une unité de mesure commune (407), reliée au premier commutateur pouvant être commandé (111) et à l'autre commutateur pouvant être commandé (113, 115), destinée à mesurer une grandeur de mesure électrique commune, en particulier une résistance interne, une tension ou un courant, du premier accumulateur d'énergie (103) et de l'autre accumulateur d'énergie (105, 107).

2. Agencement de mesure (100) selon la revendication 1, dans lequel l'agencement de circuit (109) est réalisé pour connecter en parallèle le premier accumulateur d'énergie (103) et l'autre accumulateur d'énergie (105, 107) en cours de fonctionnement de l'accumulateur d'énergie (103, 105, 107).

3. Agencement de mesure (100) selon la revendication 1 ou 2, qui peut fonctionner dans un mode test et dans un mode opérationnel, la grandeur de mesure électrique du premier accumulateur d'énergie (103) et la grandeur de mesure électrique de l'autre accumulateur d'énergie (105, 107) étant détectées en mode test, et l'agencement de circuit (109) étant réalisé en mode opérationnel pour connecter en parallèle le premier accumulateur d'énergie (103) et l'autre accumulateur d'énergie (105, 107).

4. Agencement de mesure (100) selon l'une quelconque des revendications précédentes, dans lequel le dispositif de mesure (117) est réalisé pour détecter la grandeur de mesure électrique du premier accumulateur d'énergie (103) et la grandeur de mesure électrique de l'autre accumulateur d'énergie (105, 107) dans des intervalles de mesure consécutifs dans le temps, dans lequel, à l'intérieur d'un intervalle de mesure, exactement un seul commutateur (111, 113, 115) de l'agencement de circuit (109) est fermé et tous les autres commutateurs (111, 113, 115) de l'agencement de circuit (109) sont ouverts.

5. Agencement de mesure (100) selon la revendication 4, le dispositif à processeur (119) étant réalisé, à l'intérieur d'un premier intervalle de mesure, pour maintenir fermé seul le premier commutateur (111) et pour ouvrir l'autre commutateur (113, 115), et à l'intérieur d'un autre intervalle de mesure, pour maintenir fermé seul l'autre commutateur (113, 115) et pour ouvrir le premier commutateur (111).

6. Agencement de mesure (100) selon l'une quelconque des revendications précédentes, dans lequel le dispositif à processeur (119) est réalisé pour évaluer les grandeurs de mesure électriques mesurées, en particulier pour les comparer avec des grandeurs de référence électriques afin de détecter un dysfonctionnement du premier accumulateur d'énergie (103) ou de l'autre accumulateur d'énergie (105, 107).

7. Agencement de mesure (100) selon la revendication 6, dans lequel le dispositif à processeur (119) est réalisé, lorsqu'un dysfonctionnement du premier accumulateur d'énergie (103) est détecté, pour ouvrir de façon permanente le premier commutateur pouvant être commandé (111) afin de déconnecter le premier accumulateur d'énergie (103), ou lorsqu'un dysfonctionnement de l'autre accumulateur d'énergie (105, 107) est détecté, pour ouvrir de façon permanente l'autre commutateur pouvant être commandé (113, 115) afin de déconnecter l'autre accumulateur d'énergie (105, 107).

8. Agencement de mesure (100) selon l'une quelconque des revendications précédentes, dans lequel l'agencement de circuit (109) est réalisé pour connecter en parallèle le premier accumulateur d'énergie électrique (103) et l'autre accumulateur d'énergie électrique (105, 107), et le dispositif de mesure étant réalisé pour détecter une polarité de la grandeur de mesure électrique du premier accumulateur d'énergie (103) et une polarité d'une autre grandeur de mesure électrique dans l'agencement d'accumulateur d'énergie (101), le dispositif à processeur (119) étant réalisé pour identifier le dysfonctionnement de l'agencement d'accumulateur d'énergie (101) par une comparaison de la polarité de la grandeur de mesure électrique du premier accumulateur d'énergie (103) et de la polarité de l'autre grandeur de mesure électrique, la grandeur de mesure électrique et l'autre grandeur de mesure électrique étant respectivement une tension ou un courant.

9. Agencement de mesure (100) selon la revendication 8, dans lequel le dispositif à processeur (119) est réalisé pour identifier le dysfonctionnement d'un accumulateur d'énergie (103, 105, 107) de l'agencement d'accumulateur d'énergie (101) si la polarité de la grandeur de mesure électrique du premier accumulateur d'énergie (103) et la polarité de l'autre grandeur de mesure électrique sont différentes.

10. Agencement de mesure (100) selon la revendication 8 ou 9, dans lequel le dispositif de mesure (117) est réalisé pour détecter la polarité de la grandeur de mesure électrique du premier accumulateur d'énergie (103) et la polarité de l'autre grandeur de mesure électrique par la détection d'un sens électrique de la grandeur de mesure électrique du premier accumulateur d'énergie (103) et de l'autre grandeur de mesure électrique.

11. Agencement de mesure (100) selon l'une quelconque des revendications 8 à 10, dans lequel une première unité de mesure (401) est réalisée pour détecter la polarité de la grandeur de mesure électrique du premier accumulateur d'énergie (103), et dans lequel une autre unité de mesure (403, 405) est réalisée pour détecter la polarité de l'autre grandeur de mesure électrique.

12. Agencement de mesure (100) selon la revendication 11, dans lequel le dispositif de mesure (117) présente une unité de mesure (407) commune pour détecter la polarité de la grandeur de mesure électrique à la jonction (509) du premier accumulateur d'énergie (103) et de l'autre accumulateur d'énergie (105, 107) afin d'obtenir une polarité commune, et dans lequel le dispositif à processeur (119) est réalisé pour identifier le dysfonctionnement de l'agencement d'accumulateur d'énergie (101) par une comparaison de la polarité de la grandeur de mesure électrique du premier accumulateur d'énergie (103) ou de la polarité de l'autre grandeur de mesure électrique avec la polarité commune.

13. Agencement de mesure (100) selon l'une quelconque des revendications précédentes, dans lequel l'agencement de mesure (100) présente une borne de liaison pour relier l'agencement de circuit (109) à un dispositif d'alimentation en énergie auxiliaire (121), en particulier à une alimentation en tension continue, afin de mettre les accumulateurs d'énergie électrique à la disposition de l'alimentation en énergie auxiliaire.

14. Dispositif d'alimentation en énergie auxiliaire (121) pour la fourniture d'énergie indépendamment du réseau, dans lequel un agencement de mesure (100) selon l'une quelconque des revendications précédentes est intégré dans le dispositif d'alimentation en énergie auxiliaire (121).
